(19) Europäisches Patentamt
European Patent Office
Office européen des brevets

(11) EP 0 806 684 A1

(12) EUROPÄISCHE PATENTANMELDUNG

(43) Veröffentlichungstag:
12.11.1997 Patentblatt 1997/46

(51) Int. Cl.⁶: **G02B 6/293**, G02B 6/42, H01S 3/085, H01S 3/025

(21) Anmeldenummer: 96107309.5

(22) Anmeldetag: 09.05.1996

(84) Benannte Vertragsstaaten:
CH DE ES FR GB IT LI SE

(71) Anmelder: ROBERT BOSCH GMBH
70442 Stuttgart (DE)

(72) Erfinder:
• Kuke, Albrecht, Dr.-Ing.
71549 Auenwald (DE)
• Hirche, Klaus, Dipl.-Ing.
71332 Waiblingen (DE)

(54) **Optisches Sende- und Empfangsmodul**

(57) Es wird ein optisches Sende- und Empfangsmodul für den bidirektionalen Wellenlängenmultiplex angegeben, das einen besonders einfachen Aufbau aufweist. Dazu wird eine Laserdiode eingesetzt, die zumindest eine lichtemittierende Laserendfläche (LE) aufweist, die in einem von 90° abweichenden Winkel zur Richtung der Wellenführung in der Laserdiode (LD) steht. Diese geneigte Laserendfläche (LE) weist eine wellenlängenselektive Beschichtung auf, die für Licht der ersten Wellenlänge, wie es von der Laserdiode (LD) emittiert wird, durchlässig ist und für Licht einer zweiten Wellenlänge reflektierend ist. Aus einem Lichtwellenleiterende (F), das zum Übertragen von Licht der beiden vorgegebenen Wellenlängen geeignet ist, trifft Licht der zweiten Wellenlänge auf die Beschichtung (B) der Laserdiode (LD), wird dort reflektiert und trifft auf eine Empfangsdiode (PD). Das aus dem Laser austretende Licht der ersten Wellenlänge tritt durch die Beschichtung (B) hindurch, wird gebrochen und in das Lichtwellenleiterende (F) eingekoppelt.

FIG. 1

EP 0 806 684 A1

**Beschreibung**

Stand der Technik

Die Erfindung betrifft ein optisches Sende- und Empfangsmodul für bidirektionale Übertragung mit Wellenlängenmultiplex mit einer Laserdiode zum Senden von Licht einer ersten Wellenlänge, mit einer Empfangsdiode zum Empfangen von Licht einer zweiten Wellenlänge und mit einem Lichtwellenleiterende zum Übertragen von Licht der beiden vorgegebenen Wellenlängen.

Aus der DE 38 01 764 ist ein mikrooptischer Multiplexer bekannt. Auf einem Siliziumsubstrat sind mit Hilfe der anisotropen Ätztechnik V-Nuten und Vertiefungen hergestellt, in die Kugellinsen, Glasfasern und Filterplättchen eingelegt werden können. Ein optisches Sende- und Empfangsmodul für bidirektionale Übertragung mit Wellenlängenmultiplex besteht bei einer nach diesem Stand der Technik ausgeführten Anordnung aus einer Laserdiode, einem Filterplättchen, einer Empfangsdiode und einem Lichtwellenleiterende, die in entsprechende Vertiefungen in dem Siliziumträger eingelegt sind. Zur Strahlanpassung sind zwischen den einzelnen Komponenten und dem Filterplättchen Linsen vorgesehen. Die Herstellung der Halterungen für das Filterplättchen ist sehr aufwendig.

Ausgehend von diesem Stand der Technik ist es Aufgabe der Erfindung, einen vereinfachten Aufbau für ein optisches Sende- und Empfangsmodul für bidirektionale Übertragung mit Wellenlängenmultiplex anzugeben. Die Aufgabe wird durch eine Anordnung mit den Merkmalen des Patentanspruches 1 gelöst. Vorteilhafte Weiterbildungen sind in den Unteransprüchen angegeben.

Durch den Einsatz einer Laserdiode mit einer wellenlängenselektiven Beschichtung in einem optischen Sende- und Empfangsmodul für bidirektionale Übertragung mit Wellenlängenmultiplex ergibt sich der Vorteil, daß der Einsatz einzelner Filterplättchen entfällt und daß diese somit auch nicht in Halterungen fixiert und justiert werden müssen. Die an der Laserdiode vorgesehene Beschichtung kann bereits bei der Herstellung der Laserdiode mit den bekannten Verfahren der Halbleitertechnik vorgenommen werden. Eine Beschichtung der lichtemittierenden Laserendfläche ist ohnehin zur Passivierung der Laserendfläche erforderlich. Zur Wellenlängenselektion und räumlichen Trennung ist es notwendig, daß die Richtung der Wellenführung im Laser und die lichtemittierende Laserendfläche in einem von 90° abweichenden Winkel zueinander stehen. Daher muß ein Laser zum Einsatz kommen, dessen Funktion als Laser nicht auf der Reflexion an den Kristallendflächen beruht. Dieses Kriterium wird beispielsweise von DFB- oder DBR-Lasern erfüllt. Bei diesen Lasern ist es sogar vorteilhaft, wenn das Licht an den Kristallendflächen nicht zurück in den Wellenleiter reflektiert wird.

Für die vorliegende Erfindung ist es erforderlich, daß mindestens eine lichtemittierende Endfläche in einem bestimmten Winkel zum Lichtwellenleiterende und zur Empfangsdiode sowie zur Richtung der Wellenführung im Laser angeordnet wird. Die Winkel zwischen dieser geneigten lichtemittierenden Laserendfläche und den Seitenflächen bzw. der zweiten Laserendfläche können so gewählt werden, wie es fertigungstechnisch am günstigsten ist, zum Beispiel zur Ausnutzung von Kristallebenen. Es ist besonders vorteilhaft, die Seitenflächen derart zu wählen, daß sie parallel zu den Seitenflächen von anisotrop geätzten Führungsnuten in einem Siliziumträger angeordnet werden können. Dies erspart zusätzliche Justierschritte bei der Montage der Laserdiode auf einem Siliziumträger.

Ausführungsbeispiele der Erfindung werden anhand der Zeichnungen erläutert. Es zeigen:

Figur 1 ein optisches Sende- und Empfangsmodul,
Figuren 2a bis d verschiedene Ausgestaltungen der Laserdiode mit wellenlängenselektivem Filter,
Figur 3 einen Aufbau auf einem Silizium-Träger mit geätzten Vertiefungen,
Figur 4 einen weiteren Aufbau auf einem Silizium-Träger mit geätzten Vertiefungen,
Figur 5 einen Aufbau mit mehreren übereinanderliegenden Trägern,
Figuren 6a bis c verschiedene Schnitte durch einen Aufbau gemäß Figur 5,
Figur 7 eine zusätzliche Variante zur Anordnung gemäß Figur 5 mit einer horizontal angeordneten Faser,
Figur 8 eine weitere Anordnungsmöglichkeit für die Laserdiode.

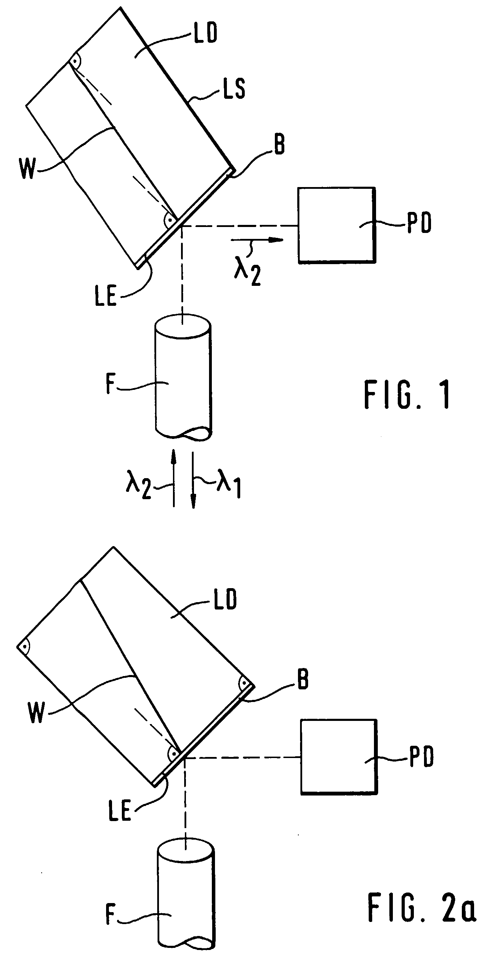

Figur 1 zeigt ein erfindungsgemäßes optisches Sende- und Empfangsmodul für bidirektionale Übertragung mit Wellenlängenmultiplex. Es ist eine Laserdiode LD vorgesehen zum Senden von Licht einer ersten Wellenlänge $\lambda_1$. Weiter ist eine Empfangsdiode PD zum Empfangen von Licht einer zweiten Wellenlänge $\lambda_2$ vorgesehen. Außerdem ist ein Lichtwellenleiterende F vorgesehen, daß zum Übertragen von Licht der beiden vorgegebenen Wellenlängen $\lambda_1$ und $\lambda_2$ dient. Die Laserdiode LD ist beispielsweise ein DFB- oder ein DBR-Laser, dessen Funktion nicht auf der Reflexion des Lichts an den Laserendflächen beruht. In Figur 1 ist die Lage des Wellenleiters W in der Laserdiode LD durch einen Strich angedeutet. Die Richtung der Wellenführung in der Laserdiode LD liegt also parallel zur Lage des Wellenleiters W. Die Laserseitenflächen LS verlaufen parallel zum Wellenleiter W. Eine lichtemittierende Laserendfläche LE ist nicht senkrecht zur Richtung des Wellenleiters W und somit zur Richtung der Wellenführung in der Laserdiode LD angeordnet. Die Endfläche LE und die Richtung der Wellenführung stehen in einem von 90° abweichenden Winkel zueinander. Diese zur Richtung der Wellenführung geneigte Laserendfläche LE weist eine wellenlängenselektive Beschichtung B auf. Die Beschichtung B ist für Licht der Wellenlänge $\lambda_1$ durchlässig und für Licht der Wellenlänge $\lambda_2$ reflektierend. Licht aus dem Lichtwellenleiterende F der Wellenlänge $\lambda_2$ wird an der Beschichtung B reflektiert und fällt auf die Empfangsdiode PD. Licht aus der Laserdiode LD der Wellenlänge $\lambda_1$ wird durch die wellenlängenselektive Beschichtung B hindurchgelassen, wird beim Austritt aus der Beschichtung gebrochen und dann in das Lichtwellenleiterende eingekoppelt.

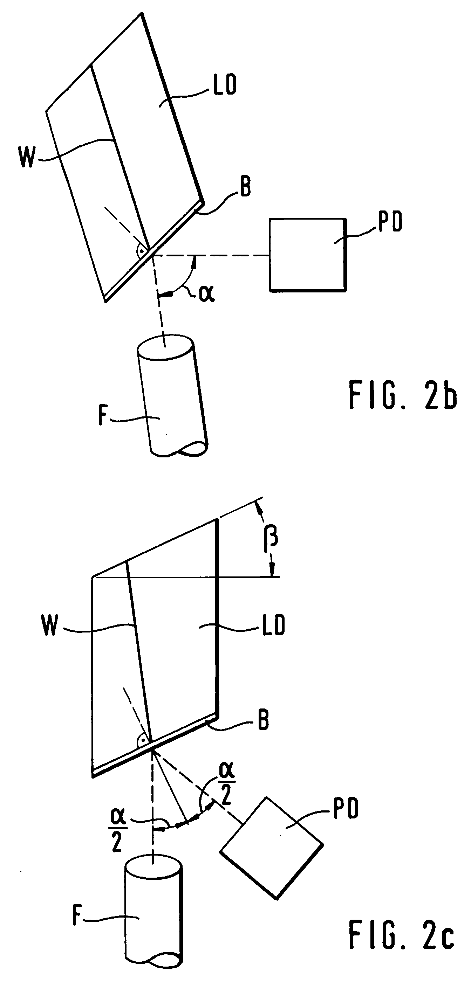

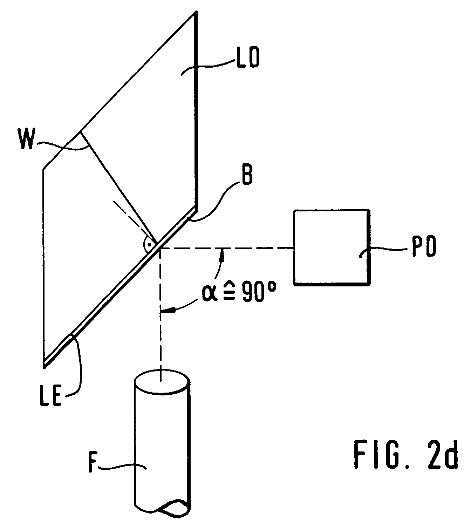

Es gibt eine ganze Reihe von Möglichkeiten, wie eine Laserdiode zum Einsatz in einem erfindungsgemäßen optischen Sende- und Empfangsmodul aussehen kann. Es ist beispielsweise möglich, daß in einer an sich quaderförmigen Laserdiode der Wellenleiter W gegen die Seitenflächen geneigt angeordnet ist (Figur 2a). Es ist auch möglich, daß die Laserdiode im Schnitt rautenförmig ist und der Wellenleiter parallel zu den Seitenflächen der Laserdiode angeordnet ist (Figur 2b). Der Winkel $\alpha$ zwischen einfallendem Licht und reflektiertem Licht kann dabei auch ungleich 90° gewählt werden. Es ist nicht notwendig, daß beide lichtemittierenden Laserendflächen gegen den Wellenleiter W geneigt sind. Die lichtemittierende Endfläche, die nicht ausgenutzt wird, kann einen beliebigen Winkel $\beta$ zur Senkrechten auf der Seitenfläche der Laserdioden LD aufweisen. Für die Montage der Laserdiode und der Faser auf einem Siliziumträger ist es von besonderem Vorteil, wenn die Seitenfläche der Laserdiode und die Faserachse parallel zueinander angeordnet werden können (Figur 2c). Figur 2d zeigt eine Anordnung, bei der der Winkel zwischen dem Strahlengang von der Faser F zur Laserdiode LD und von der Laserdiode LD zur Empfangsdiode PD 90° beträgt. Da die Lage des Wellenleiters in der Laserdiode und der Winkel der Laserendfläche LE frei wählbar sind, kann der Winkel $\alpha$ beliebig bestimmt werden.

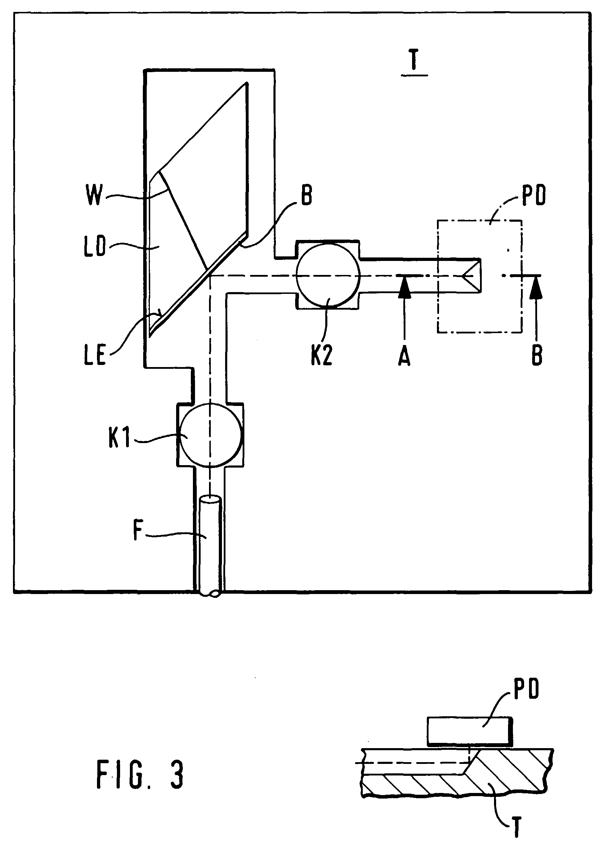

Figur 3 zeigt eine Anordnung gemäß Figur 2d, die in einen Siliziumträger T mit anisotrop geätzten V-Nuten und Vertiefungen eingebracht ist. Jeweils zwischen der Empfangsdiode PD und dem Lichtwellenleiter F und der Laserdiode LD ist eine Kugellinse K1, K2 vorgesehen, mit der eine Strahlanpassung und Fokussierung durchgeführt wird. Die Empfangsdiode PD ist nicht in einer Vertiefung, sondern auf dem Silizium-Träger T montiert. In der unteren kleinen Zeichnung ist ein Schnitt von A nach B dargestellt, der zeigt, daß der auf die Fotodiode fallende Lichtstrahl an der geneigten Stirnfläche der V-Nut reflektiert wird und auf die Fotodiode fällt. Eine Seitenfläche der Laserdiode ist parallel zum Lichtwellenleiter F angeordnet. Aufgrund der anisotropen Ätztechnik sind Anschläge im Silizium-Träger T geätzt, die zu dieser Seitenfläche parallel sind und die die Justage der Laserdiode vereinfachen. Dadurch ist die Lage der Laserdiode jedoch nur in einer Richtung festgelegt.

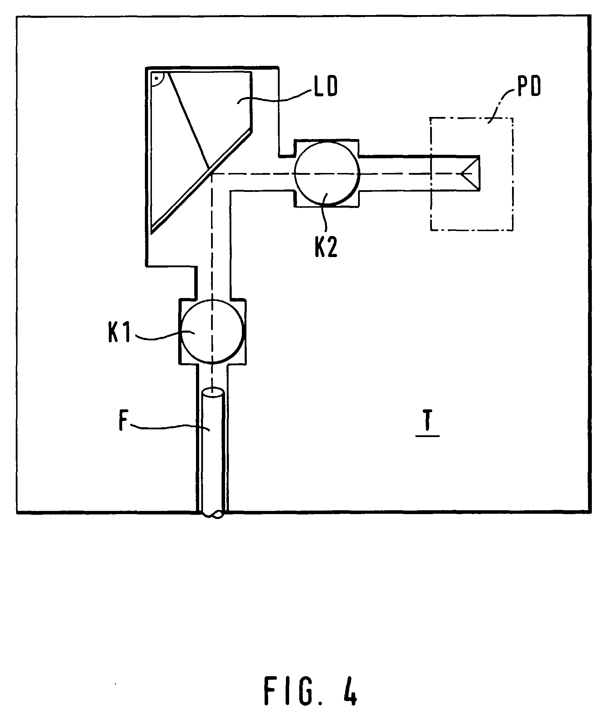

Figur 4 zeigt eine entsprechende Anordnung in der die zweite lichtemittierende Laserendfläche in einem rechten Winkel zur Seitenfläche des Lasers steht. Da auch Anschläge auf dem Silizium-Träger T einen rechten Winkel zueinander aufweisen, wenn sie anisotrop geätzt wurden, ist es dadurch möglich die Laserdiode LD in beiden Richtungen mit Hilfe dieser Anschläge zu justieren.

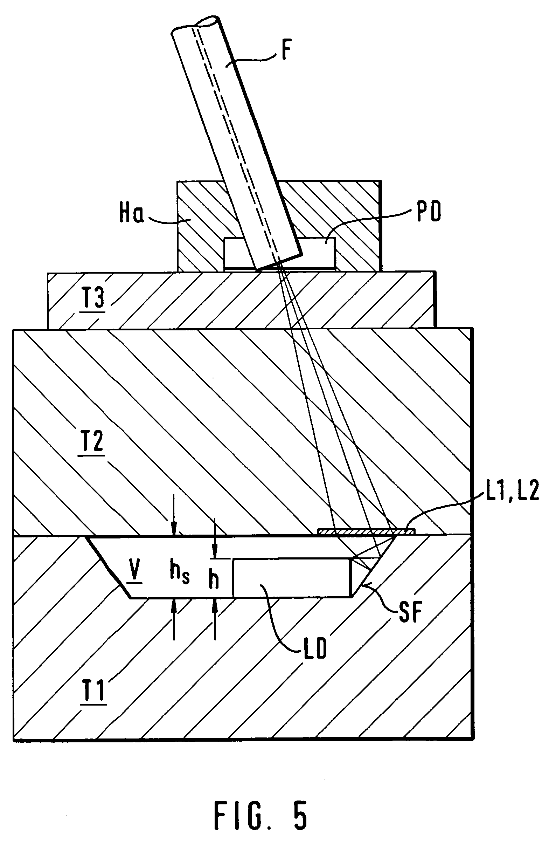

Ein Problem der bisher beschriebenen Ausführungsbeispiele besteht darin, daß zwischen der Laserdiode und der Faser wegen der unterschiedlichen Strahlcharakteristiken von Laserdiode und Einmodenfaser eine Strahltransformation erforderlich ist. Der in der Faser geführte Strahl muß dabei so transformiert werden, daß er an der Stirnfläche des Lasers etwa die gleiche Divergenz wie der Laser besitzt. Der an der Laserstirnfläche reflektierte Empfangsstrahl wird also eine sehr große Divergenz besitzen. Für eine effektive Ankopplung einer Photodiode muß diese entweder eine sehr große aktive Fläche besitzen, was sich nachteilig auf die erreichbare Grenzfrequenz auswirkt, oder die Photodiode muß sehr dicht an der Laserstirnfläche sitzen, was Platzprobleme und Probleme mit elektrischem Übersprechen ergibt oder es muß ebenfalls eine Koppeloptik verwendet werden. Beim folgenden Ausführungsbeispiel (Figur 5) tritt dieses Problem nicht auf.

Die Laserdiode LD sitzt an einer in einem Siliziumträger T1 anisotrop geätzten Vertiefung mit ebenem Boden und um 54,7° geneigten Seitenflächen SF, von denen mindestens eine verspiegelt ist. Die lichtemittierende Stirnfläche des Lasers endet so nah wie möglich vor einer verspiegelten Seitenfläche der Vertiefung. Das aus dem Laser austretende Lichtbündel, dessen Mittenstrahl erfindungsgemäß nicht in Richtung der Flächennormalen der Laserstirnseite austritt, sondern mit dieser einen horizontalen Winkel $\alpha$ einschließt, wird an der geneigten Stirnseite schräg nach oben und vorn reflektiert. Das aus der Faser austretende Empfangslichtbündel trifft nach Durchlaufen der Linse L1 und nach Reflexion an der Seitenfläche SF auf die Laserstirnfläche und wird dort unter dem Winkel $-\alpha$ reflektiert. Nach einer wei-teren Reflexion an der Seitenfläche SF durchläuft es die Linse L2 und wird in die Empfangs-Photodiode PD fokussiert. Der Winkel $\alpha$ muß dabei mindestens so groß sein wie der horizontale Fernfeldwinkel des Lasers, um eine ausreichende Trennung von Sende- und Empfangsstrahl zu erreichen. Bei einem typischen Laser mit einem Fernfeld von 25° (FWHM) in horizontaler und 35° (FWHM) in vertikaler Richtung erhält man aus

$$\theta_{1/e^2} = 1/\sqrt{2*\ln(2)} \ * \ FWHM$$

für die Winkel der Randstrahlen

$$\theta_{1/e^2} \ ,$$

bei denen die Intensität auf das $1/e^2$-fache der Mittenintensität abgefallen ist, $\pm21,2°$ in horizontaler Richtung und $\pm29,7°$ in vertikaler Richtung. Der Winkel $\alpha$ muß also größer als $21,2°$ sein. Rechnet man mit $\alpha = 25°$, so ist bei einem Brechungsindex des Lasers von 3,2 ein Winkel $\beta$ zwischen der Flächennormalen des Lasers und der Richtung der aktiven Zone von

$$\beta = \arcsin((n_2/n_1)^*\sin\alpha) = 7,6°$$

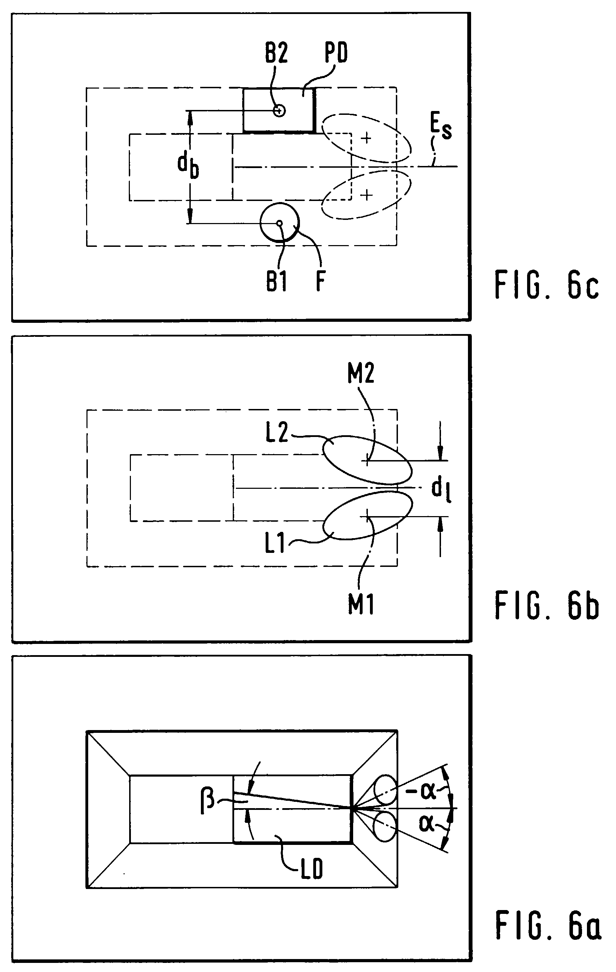

erforderlich. Über dem Siliziumträger mit der Vertiefung V zur Aufnahme des Lasers wird ein weiterer Träger T2 mit zwei Linsen in einer Ebene parallel zur Oberfläche des Siliziumträgers angebracht (Figur 6b). Diese Linsen können beispielsweise mikrostrukturierte Fresnellinsen auf einem Träger aus Glas oder Silizium oder einem sonstigen geeigneten Material sein. Ebenso sind holographisch erzeugte Linsen möglich. auch Linsen, die durch bekannte Trockenätzverfahren in Silizium hergestellt werden können, sind hier geeignet. Die Linsen liegen symmetrisch zu einer Symmetrieebene $E_s$, die die Flächennormale der Laserstirnfläche, das Lichtaustrittsfenster des Lasers und die Flächennormale des Siliziumträgers enthält. Diese Ebene ist die yz-Ebene eines rechtwinkligen Koordinatensystems, dessen z-Achse die Flächennormale der Laserstirnfläche und deren y-Achse die Flächennormale des Siliziumsubstrats ist. Die x-Achse liegt in der aktiven Schicht des Lasers. Die eine Linse liegt im Strahlengang des Lasers bzw. des aus der Faser austretenden Empfangssignals und die andere im Strahlengang des an der Laserstirnfläche reflektierten Empfangssignals. Die Mittelpunkte beider Linsen haben einen Abstand $d_1$ voneinander, der sich aus dem Winkel $\alpha$ und dem Lichtweg g von der Laserstirnfläche bis zum jeweiligen Linsenmittelpunkt zu

$$d_1 = 2^*g^*\tan\alpha$$

ergibt. Durch diese Linsen wird das Lichtaustrittsfenster des Lasers auf die beiden Bildpunkte B1 und B2 abgebildet, die einen Abstand b in Strahlrichtung von den jeweiligen Linsen haben (Figur 6c). Der Abstand $d_b$ der Bildpunkte voneinander beträgt

$$d_b = 1^*(g+b)^*\tan\alpha.$$

Aus der Bildweite b und der Gegenstandsweite g der Abbildung erhält man die Vergrößerung

$$M = b/g.$$

Die Brennweite f der beiden Linsen errechnet sich nach der Linsengleichung zu

$$f = M^*g/(M + 1)$$

und die Bildweite b zu

$$b = f^*(M + 1).$$

Beispielhaft soll für einen Laser mit dem oben angeführten Fernfeld und einer Dicke von $100\mu m$, dessen aktiver Zone auf seiner Oberseite in einer Höhe $h = 95\mu m$ über der Chipauflage liegt, und der mit seinem unteren Chiprand unmittelbar an den Fuß der Seitenwand stößt die erforderliche Geometrie berechnet werden. Der Lichtweg $g_1$ des Mittenstrahls vom Lichtaustrittsfenster des Lasers bis zur Seitenwand ist

$$g_1 = h/\sqrt{2} * \cos\alpha = 74,1\ \mu m.$$

Damit das ganze Laserlichtbündel die reflektierende Seitenfläche treffen kann, muß diese bis zu einer Höhe

$$h_s = H/(1 - \tan(\theta_s)/\sqrt{2}) = 160\mu m$$

reichen. Der an der Stirnfläche reflektierte Mittenstrahl ist in seiner Projektion auf die Symmetrieebene um den Richtungswinkel

$$\gamma_{zy} = 2^*\arctan(\sqrt{2}) - 90° = 19,5°$$

gegen die Flächennormale der Substratoberfläche geneigt. Außerdem ist der Mittenstrahl in der xy-Ebene unter dem Winkel

$$\gamma_{xy} = \arctan(\tan(\alpha)/\cos(\gamma_{zy})) = 26{,}3°$$

gegen die Flächennormale der Substratoberfläche geneigt.

Die Länge $g_2$ des Mittenstrahls von der Reflexionsstelle an der Seitenwand bis zur Unterseite des Linsenstägers ist

$$g_2 = (h_s - h)/(\cos(\gamma_{zy})^*\cos \alpha) = 76{,}1 \ \mu m.$$

Zur gesamten Gegenstandweite kommt noch der Lichtweg $g_3$ von der Unterseite des Linsenträgers bis zum Linsenmittelpunkt hinzu. Dieser zusätzliche Lichtweg hängt von der Art der verwendeten Linse ab. Bei der Fresnellinse oder einer holographischen Linse ist $g_3 = 0$. Die Gegenstandsweite ist dann

$$g = g_1 + g_2 + g_3 = 74{,}1\mu m + 76{,}1\mu m + 0\mu m = 150{,}2 \ \mu m.$$

Ist zur Strahltransformation ein Vergrößerungsverhältnis von $M = 4{,}5$ erforderlich, so ist die erforderliche Brennweite der Linse $f = 123\mu m$. Die Bildweite ist dann $676\mu m$. Dieses Zahlenbeispiel bezieht sich auf die Minimalkonfiguration von Gegenstands- , Bild- und Brennweite für den oben beschriebenen Laser. Größere Werte können entsprechend der Möglichkeiten der eingesetzten Linse ebenfalls verwendet werden.

In der Bildebene, die im Abstand

$$b' = b^*(\cos(\gamma_{zy})^*\cos \alpha) = 578\mu m$$

über der Linsenebene liegt, wird die Faser und die Photodiode montiert. Der Abstand $d_b$ der Bildpunkte $B_1$ für die Faser und $B_2$ für die Photodiode ist im Zahlenbeispiel

$$d_b = 2^*(150 + 676)^*\tan(25) = 770\mu m.$$

Der Bildpunkt für die Faser ist infolge der zweimaligen Abbildung mit M und 1/M gerade so groß wie der Modenfelddurchmesser der Faser, der bei Standardeinmodenfasern bei $10\mu m$ liegt. Montagetoleranzen des Lasers relativ zu der Linsenträgerplatte wirken sich gleichartig auf die Lage der beiden Bildpunkte $B_1$ und $B_2$ aus und werden entsprechend dem Vergrößerungsverhältnis M der Abbildung vergrößert. Auf den gegenseitigen Abstand $d_b$ beider Bildpunkte wirkt sich die Dejustage des Lasers jedoch nicht aus. Dieser Abstand wird durch den Abstand der Linsenmitten $d_1$ und in geringem Maß von der Gegenstands- und Bildweite bestimmt. Bei gleichzeitiger Erzeugung beider Linsen in einem photolithografischen Prozeß kann der Linsenabstand sehr genau eingehalten werden. Bringt man den Halter Ha für die Faser und die Photodiode auf einen gemeinsamen Träger T3, so wird bei der Justage der Faser, die zum Ausgleich der Montagetoleranzen des Lasers erforderlich ist, gleichzeitig auch die Photodiode mit nahezu der gleichen Genauigkeit mitjustiert. Dadurch und wegen der geringen Größe der Strahltaille im Bildpunkt $B_2$ läßt sich eine Photodiode mit einem sehr kleinen Durchmesser der aktiven Zone einsetzen, womit sehr hohe Grenzfrequenzen im GHz-Bereich möglich sind. Bei einem Durchmesser der aktiven Zone der Photodiode von $30\mu m$ bleiben für die Montage der Photodiode auf dem gemeinsamen Träger noch laterale Toleranzen zur Position des Faserkerns von $\pm 10\mu m$, die noch mit einer passiven Montage mit Hilfe von Justagemarken erreicht werden können.

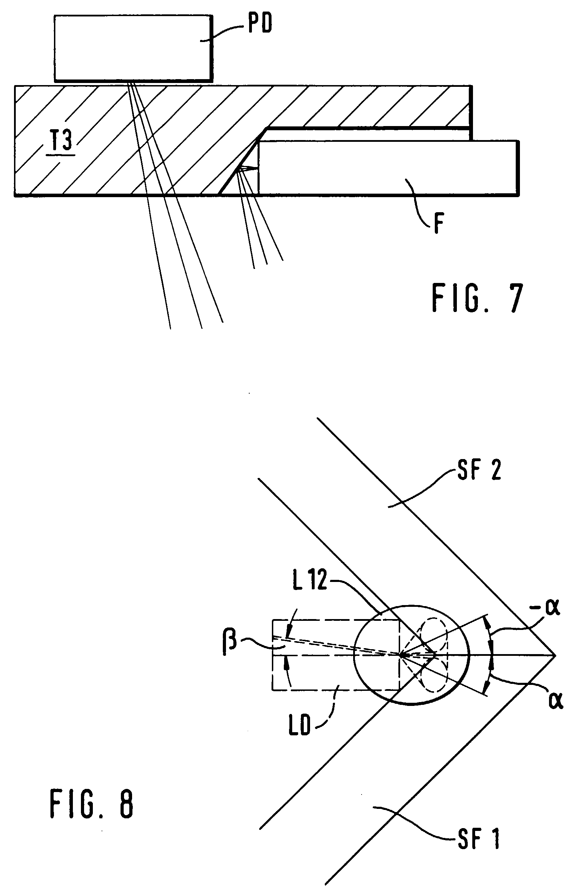

Da der Strahlverlauf gegenüber der Normalen der Substratoberfläche um die Richtungswinkel $\gamma_{zy}$ und $\gamma_{xy}$ geneigt ist, muß entweder die Faser in ihrer Aufnahme ebenfalls so geneigt sein oder diese Neigung muß bei senkrechter Montage der Faser durch einen entsprechenden Schliffwinkel der Faserstirnfläche kompensiert werden. Letzteres hätte den Vorteil, daß dabei schädliche Rückreflexionen von der Faserstirnfläche auf den Laser vermieden werden. Auch eine horizontale Montage der Faser, beispielsweise in einem anisotrop geätzten Siliziumträger mit einer V-Nut zur Aufnahme der Faser, ist möglich. Das Empfangs- und Sendelichtbündel wird dann an der verspiegelten Stirnfläche der Faser-V-Nut umgelenkt (siehe Figur 7).

Ein zweiter Vorschlag zur Strahlführung ist in der Figur 8 dargestellt. Hier ist der Laserchip ebenfalls auf dem Boden einer Vertiefung montiert. Im Unterschied zum ersten Vorschlag sitzt der Laser hier nicht mit seiner Kante parallel zur Fußkante einer Seitenfläche der Vertiefung sondern vor einer Ecke zweier benachbarter verspiegelter Seitenflächen, so daß das Sendelichtbündel die eine Seitenfläche und das Empfangslichtbündel die andere Seitenfläche trifft. Die beiden an den Seitenflächen reflektierten Lichtbündel des Sende- und Empfangsstrahls kreuzen sich. In den Kreuzungspunkt wird eine einzelne Linse für beiden Strahlen angebracht. Da beide Strahlen von verschiedenen Spiegelbildern des Lasers, entsprechend der Reflexion an den verschiedenen Seitenflächen, ausgehen, sind auch ihre Bildpunkte trotz der Abbildung mit nur einer Linse an verschiedenen Orten $B_1$ und $B_2$. In diesen Bildpunkten wird, wie im Vorschlag 1 ausgeführt, die Montage und Justage von Faser und Photodiode durchgeführt.

**Patentansprüche**

1.  Optisches Sende- und Empfangsmodul für bidirektionale Übertragung mit Wellenlängenmultiplex mit einer Laserdiode (LD) zum Senden von Licht einer ersten Wellenlänge, mit einer Empfangsdiode (PD) zum Empfangen von Licht einer zweiten Wellenlänge und mit einem Lichtwellenleiterende (F) zum Übertragen von Licht der beiden vorgegebenen Wellenlängen,

    dadurch gekennzeichnet, daß die Richtung der Wellenführung in der Laserdiode (LD) und zumindest eine Laserendfläche (LE), aus der das in der Laserdiode (LD) erzeugte Licht austritt, in einem von 90° abweichenden Winkel zueinander stehen,
    daß zumindest die zur Richtung der Wellenführung geneigte Laserendfläche (LE) eine wellenlängenselektive Beschichtung (B) aufweist, die für Licht der ersten Wellenlänge durchlässig und für Licht der zweiten Wellenlänge reflektierend ist,
    daß das Lichtwellenleiterende (F) zur Laserdiode (LD) derart angeordnet ist, daß Licht der ersten Wellenlänge von der Laserdiode (LD) in das Lichtwellenleiterende (F) eingekoppelt wird,
    daß die Empfangsdiode (PD) zum Lichtwellenleiterende (F) und zur Laserdiode (LD) derart angeordnet ist , daß Licht der zweiten Wellenlänge aus dem Lichtwellenleiterende (F) an der Beschichtung (B) reflektiert wird und auf die Empfangsdiode (PD) fällt.

2.  Optisches Sende- und Empfangsmodul nach Anspruch 1, dadurch gekennzeichnet, daß als Laserdiode (LD) ein DFB-Laser eingesetzt ist.

3.  Optisches Sende- und Empfangsmodul nach Anspruch 1, dadurch gekennzeichnet, daß als Laserdiode (LD) ein DBR-Laser eingesetzt ist.

4.  Optisches Sende- und Empfangsmodul nach einem der Ansprüche 1, 2 oder 3, dadurch gekennzeichnet, daß ein Silizium-Träger (T) vorgesehen ist, daß der Silizium-Träger (T) anisotrop geätzte V-Nuten und Vertiefungen aufweist, in die die Laserdiode (LD) und das Lichtwellenleiterende (F) eingelegt sind.

5.  Optisches Sende- und Empfangsmodul nach Anspruch 4, dadurch gekennzeichnet, daß auf dem Silizium-Träger (T) mindestens eine Vertiefung für eine Kugellinsen (K1,K2) im Strahlengang zwischen dem Lichtwellenleiterende (F) und der Laserdiode (LD) oder der Empfangsdiode (PD) vorgesehen sind.

6.  Optisches Sende- und Empfangsmodul nach einem der Ansprüche 1, 2 oder 3, dadurch gekennzeichnet, daß die Laserdiode (LD) in einer anisotrop geätzten Vertiefung in einem Siliziumträger (T) angebracht ist, daß eine Seitenfläche der Vertiefung verspiegelt ist, daß das aus der lichtemittierenden Laserendfläche (LE) austretende Licht an der verspiegelten Seitenfläche der Vertiefung vom Grund der Vertiefung weg reflektiert wird, daß über dem Siliziumträger (T) zumindest ein weiterer Träger vorgesehen ist, der die Empfangsdiode (PD) und das Lichtwellenleiterende (F) trägt.

7.  Optisches Sende- und Empfangsmodul nach Anspruch 6, dadurch gekennzeichnet, daß auf dem Siliziumträger (T) ein weiterer Träger vorgesehen ist, der zwei Linsen in den Strahlengang einbringt.

8.  Optisches Sende- und Empfangsmodul nach Anspruch 7, dadurch gekennzeichnet, daß die Linsen mikrostrukturierte Fresnellinsen auf einem Träger aus Glas oder Silizium sind.

9.  Optisches Sende- und Empfangsmodul nach Anspruch 7, dadurch gekennzeichnet, daß die Linsen holographisch erzeugte Linsen sind.

10. Optisches Sende- und Empfangsmodul nach Anspruch 7, dadurch gekennzeichnet, daß die Linsen durch Trockenätzverfahren in Silizium erzeugte Linsen sind.

FIG. 1

FIG. 2a

FIG. 2b

FIG. 2c

8

FIG. 2d

FIG. 3

FIG. 4

FIG. 5

FIG. 6c

FIG. 6b

FIG. 6a

FIG. 7

FIG. 8

| | Europäisches Patentamt | EUROPÄISCHER RECHERCHENBERICHT | Nummer der Anmeldung EP 96 10 7309 |
|---|---|---|---|

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | DE-C-44 07 451 (ANT NACHRICHTENTECH) 4.Mai 1995<br>* Spalte 2, Zeile 3 - Zeile 30 *<br>* Abbildung 1 *<br>--- | 1 | G02B6/293<br>G02B6/42<br>H01S3/085<br>H01S3/025 |
| A,D | DE-A-38 01 764 (ANT NACHRICHTENTECH) 3.August 1989<br>* Spalte 2, Zeile 27 - Spalte 3, Zeile 43 *<br>* Abbildungen 1,2 *<br>--- | 1 | |
| A | DE-U-93 19 378 (SIEMENS AG) 17.Februar 1994<br>* Ansprüche 1,5 *<br>* Abbildung 2 *<br>--- | 1 | |
| A | EP-A-0 631 163 (SIEMENS AG) 28.Dezember 1994<br>* Anspruch 1 *<br>* Abbildung 1 *<br>--- | 1 | |
| A | PATENT ABSTRACTS OF JAPAN<br>vol. 013, no. 568 (E-861), 15.Dezember 1989<br>& JP-A-01 238082 (NIPPON TELEGR & TELEPH CORP), 22.September 1989,<br>* Zusammenfassung *<br>--- | 1 | **RECHERCHIERTE SACHGEBIETE (Int.Cl.6)**<br>G02B<br>H01S |
| A | IEEE JOURNAL OF QUANTUM ELECTRONICS,<br>Bd. 27, Nr. 6, 1.Juni 1991,<br>Seiten 1837-1842, XP000230003<br>BUUS J ET AL: "REFLECTIVITY OF COATED AND TILTED SEMICONDUCTOR FACETS"<br>* das gesamte Dokument *<br>--- | 1 | |

-/--

Der vorliegende Recherchenbericht wurde für alle Patentansprüche erstellt

| Recherchenort | Abschlußdatum der Recherche | Prüfer |
|---|---|---|
| BERLIN | 16.Oktober 1996 | Luck, W |

Europäisches
Patentamt

Nummer der Anmeldung

EP 96 10 7309

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | ELECTRONICS LETTERS, Bd. 27, Nr. 11, 23.Mai 1991, Seiten 968-970, XP000232452 LIN C F: "SUPERLUMINESCENT DIODES WITH ANGLED FACET ETCHED BY CHEMICALLY ASSISTED ION BEAM ETCHING" * das gesamte Dokument * ----- | 1 | |
| | | | **RECHERCHIERTE SACHGEBIETE (Int.Cl.6)** |

Der vorliegende Recherchenbericht wurde für alle Patentansprüche erstellt

| Recherchenort | Abschlußdatum der Recherche | Prüfer |
|---|---|---|
| BERLIN | 16.Oktober 1996 | Luck, W |

EPO FORM 1503 03.82 (P04C03)